# EUROPÄISCHE PATENTANMELDUNG

(11) **EP 4 711 781 A1**
(43) Veröffentlichungstag der Anmeldung: **18.03.2026**
(21) Anmeldenummer: 25198114.8
(22) Anmeldetag: 26.08.2025
(51) Int. Cl.: G01R 31/327, H02H 3/00, H02H 3/04

(54) **STEUEREINHEIT FÜR EIN SCHUTZRELAIS, EIN SCHUTZRELAIS, EINE KOMMUNIKATIONSSCHNITTSTELLE, EIN SCHUTZRELAISTESTGERÄT, EIN VERFAHREN ZUM TESTEN EINES SCHUTZRELAIS, EIN COMPUTERPROGRAMM, EIN COMPUTERLESBARES SPEICHERMEDIUM UND EIN COMPUTER**

(30) Priorität: 16.09.2024 DE 102024208778
(71) Anmelder: Siemens Energy Global GmbH & Co. KG, 81739 München (DE)
(72) Erfinder: Fiebig, Jan, 02708 Löbau/ OT Kittlitz (DE)

(57) **Zusammenfassung**

Die Erfindung betrifft eine Steuereinheit (1) und/oder eine Kommunikationsschnittstelle (7) für ein Schutzrelais (2), wobei die Steuereinheit (2) in einem Speicher eine Vielzahl von Schutzfunktionen (3, 5, 6) jeweils umfassend zumindest eine Schutzstufe (4) gespeichert hat und dazu eingerichtet ist, ein Signal für ein Öffnen des Schutzrelais (2) auszugeben, wenn die jeweilige Schutzstufe (4) von einem entsprechenden Betriebsparameter des Schutzrelais (2) überschritten wurde. Für ein Testen der Vielzahl von Schutzstufen (4) und/oder Schutzfunktionen (3, 5,6) des Schutzrelais ist die Steuereinheit (1) und/oder die Kommunikationsschnittstelle (7) dazu eingerichtet, zumindest eine ausgewählte Schutzstufe (4) der ausgewählten Schutzfunktion (5) aktiv zu lassen oder zu aktivieren und alle anderen Schutzstufen (4) der ausgewählten Schutzfunktion (5) und/oder anderer Schutzfunktionen (6) der Vielzahl von Schutzfunktionen (3, 5, 6) zu deaktivieren.

## Beschreibung

### Technisches Gebiet

Die vorliegende Erfindung betrifft eine Steuereinheit für ein Schutzrelais, ein Schutzrelais umfassend die Steuereinheit, eine Kommunikationsschnittstelle zwischen einem Schutzrelaistestgerät und einer Steuereinheit eines Schutzrelais, ein Schutzrelaistestgerät und/oder eine Steuereinheit für ein Schutzrelais und/oder ein Testaufbau für ein Schutzrelais umfassend die Kommunikationsschnittstelle, ein Verfahren zum Testen eines Schutzrelais, ein Computerprogramm, ein computerlesbares Speichermedium und einen Computer.

### Stand der Technik

In den heutigen digitalen Schutzrelais kann eine Vielzahl unterschiedlicher Schutzfunktionen implementiert und aktiviert werden. Beim Generatorschutz sind beispielsweise mehr als 25 Schutzfunktionen aktiv. In einem Projekt sind mehrere hundert Schutzstufe in verschiedenen Eingabemasken zu bearbeiten, welche im Projektverlauf mehrfach getestet werden müssen. Da die verschiedenen Schutzfunktionen Wechselwirkungen untereinander unterliegen, sich daher gegenseitig beeinflussen, müssen für den Test einer Schutzfunktion (oder auch nur einer Stufe einer Schutzfunktion) die anderen Schutzfunktionen (und Schutzstufen) deaktiviert werden, um Fehlauslösungen zu vermeiden. Dies geschieht derzeit manuell durch Entfernen der entsprechenden Schutzstufen (Grenzwerte). Dies verursacht viele Fehlauslösungen und stellt einen hohen manuellen Aufwand dar. Zudem kann nach Abschluss der Prüfungen nicht sichergestellt werden, dass alle relevanten Schutzstufen exakt entsprechend den Vorgaben für das Schutzrelais wieder eingetragen wurden.

### Darstellung der Erfindung

Es ist daher eine Aufgabe der vorliegenden Erfindung, eine verbesserte Steuereinheit eines Schutzrelais und/oder ein verbessertes Schutzrelais bereitzustellen.

Eine Lösung wird durch den Gegenstand gemäß den unabhängigen Ansprüchen bereitgestellt. Vorteilhafte weitere Ausführungsformen der Erfindung sind in den abhängigen Ansprüchen, in der nachfolgenden Beschreibung und in den Figuren beschrieben.

Die Erfindung betrifft eine Steuereinheit für ein Schutzrelais, welche in einem Speicher eine Vielzahl von Schutzfunktionen jeweils umfassend zumindest eine Schutzstufe gespeichert hat und welche dazu eingerichtet ist, ein Signal für eine Schutzauslösung des Schutzrelais auszugeben, wenn die jeweilige Schutzstufe von zumindest einem Betriebsparameter des Schutzrelais ausgelöst wurde.

Erfindungsgemäß ist die Steuereinheit dazu eingerichtet, zumindest eine ausgewählte Schutzstufe einer ausgewählten Schutzfunktion aktiv zu lassen oder zu aktivieren und alle anderen Schutzstufen der ausgewählten Schutzfunktion und/oder anderer Schutzfunktionen der Vielzahl von Schutzfunktionen zu deaktivieren.

Ergänzend oder alternativ kann die Steuereinheit dazu eingerichtet sein, die ausgewählte Schutzfunktion, insbesondere alle Schutzstufen davon, aktiv zu lassen oder zu aktvieren und alle anderen Schutzfunktionen, insbesondere alle Schutzstufen der jeweiligen anderen Schutzfunktion, zu deaktivieren.

Mit anderen Worten, die Steuereinheit kann eine Datenstruktur, umfassen, welche so ausgebildet ist, dass durch ein Auswählen von zumindest einer Schutzstufe alle anderen Schutzstufen, insbesondere in derselben Schutzfunktion und/oder in allen anderen Schutzfunktionen der Vielzahl von Schutzfunktionen, deaktiviert werden. Hierzu kann die Datenstruktur so ausgebildet sein, dass die jeweilige Schutzstufe einer Schutzfunktion mit allen anderen Schutzstufen aller anderen Schutzfunktionen der Vielzahl von Schutzfunktionen verknüpft ist, so dass durch ein Aktivieren der Schutzstufe in einer Schutzfunktion aus der Vielzahl von Schutzfunktionen alle anderen Schutzstufen in derselben Schutzfunktion und/oder in allen anderen Schutzfunktionen aus der Vielzahl von Schutzfunktionen deaktiviert werden.

Ergänzend oder alternativ kann die besagte Datenstruktur so ausgebildet sein, dass die jeweilige Schutzstufe mit einer dazugehörigen Schutzfunktion verknüpft ist, so dass durch ein Aktivieren oder Deaktivieren der Schutzfunktion, insbesondere der anderen Schutzfunktionen aus der Vielzahl von Schutzfunktionen, alle dazugehörigen Schutzstufen aktiviert oder deaktiviert werden. Beispielsweise kann die Steuereinheit dazu eingerichtet sein, zumindest eine ausgewählte Schutzfunktion aktiv zu lassen oder zu aktivieren und alle anderen Schutzfunktionen der Vielzahl von Schutzfunktionen zu deaktivieren. Dabei kann das Aktivieren und/oder Deaktivieren einer Schutzfunktion das Aktivieren und/oder Deaktivieren aller zugehörigen Schutzstufen umfassen.

Die Schutzfunktion kann eine Vielzahl von Schutzstufen umfassen, wobei die jeweilige Schutzstufe einen Schwellenwert oder eine Kombination aus dem Schwellenwert und einem Zeitschwellenwert für zumindest einen Betriebsparameter des Schutzrelais sein kann. Der Betriebsparameter des Schutzrelais kann beispielsweise ein Strom, eine Spannung und/oder eine Netzfrequenz sein. Eine Schutzstufe kann einer Schutzfunktion beispielsweise gemäß dem Standard IEEE/ANSI 37.2 zugeordnet sein.

Beispielsweise kann die Datenstruktur als eine "Testmatrix" implementiert sein, in der die zu prüfende ausgewählte Schutzstufe oder Schutzfunktion (alle Schutzstufen der Schutzfunktion ausgewählt) beispielsweise durch ein Auswählen einer Checkbox aktiviert werden kann. Die anderen Schutzstufen und/oder Schutzfunktionen der Vielzahl von Schutzfunktionen können automatisch deaktiviert werden. Es kann immer nur eine Schutzfunktion oder optional eine Schutzstufe einer Schutzfunktion ausgewählt werden. Damit kann die ausgewählte Schutzfunktion oder optional die ausgewählte Schutzstufe einfach und schnell ohne Fehlauslösung, verursacht durch eine weitere Schutzstufe oder eine weitere Schutzfunktion, getestet und protokolliert werden. Anschließend kann eine zweite Schutzstufe oder Schutzfunktion der Vielzahl von Schutzfunktionen ausgewählt und getestet werden. Dies kann solange wiederholt werden, bis alle Schutzstufen und/oder Schutzfunktionen der Vielzahl von Schutzfunktionen getestet wurden.

Die Steuereinheit kann dazu eingerichtet sein, das Schutzrelais zu öffnen, wenn zumindest eine Schutzstufe von dem Betriebsparameter ausgelöst wird oder der Betriebsparameter einen Schwellenwert der jeweiligen Schutzstufe überschreitet. Das Schutzrelais kann für einen Netzschutz ausgebildet sein, beispielsweise für den Schutz von einem Generator oder einen Transformator. Das Schutzrelais kann dabei ein digitales Schutzrelais sein.

Hierdurch ergibt sich der Vorteil, dass eine Wechselwirkung zwischen den Schutzfunktionen bei einem Testlauf der Vielzahl von Schutzfunktionen vermieden werden kann. Weiterhin müssen die jeweiligen Schutzstufen nicht mehr von Hand einzeln aktiviert oder deaktiviert werden, sondern können auf der Ebene der Schutzfunktionen aktiviert oder deaktiviert werden. Dies gestaltet den Testlauf einfacher und ermöglicht ferner eine Automatisierung des Testlaufs. Weiterhin wird eine Bedienbarkeit beim Testen des Schutzrelais vereinfacht, welches ein Einsparpotenzial bezüglich des Testaufwands in Projekten mit sich führt. Weiterhin werden Fehlauslösungen beim Testen verhindert und die Sicherheit im Projekt und/oder in der Anlage kann signifikant erhöht werden.

Zur Steuereinheit gehören auch Ausführungsformen, durch die sich weitere Vorteile ergeben.

Eine Ausführungsform sieht vor, dass die Steuereinheit dazu eingerichtet ist, alle Schutzstufen der jeweiligen Schutzfunktion der Vielzahl von Schutzfunktionen, insbesondere der ausgewählten Schutzfunktion und/oder der anderen Schutzfunktion, zu deaktivieren. Mit anderen Worten, die Steuereinheit kann dazu eingerichtet sein, bei einem Auswählen von zumindest einer zu testenden Schutzstufe in einer Schutzfunktion alle anderen Schutzstufen derselben Schutzfunktion und/oder von allen anderen Schutzfunktionen der Vielzahl von Schutzfunktionen insbesondere gleichzeitig zu deaktivieren oder abzuwählen. Hierdurch ergibt sich der Vorteil, dass während des Testlaufs nur die zu testende Schutzfunktion aktiv ist. Ferner kann die Wahrscheinlichkeit einer Wechselwirkung zwischen zumindest zwei Schutzfunktionen weiter reduziert werden.

Eine Ausführungsform sieht vor, dass die Steuereinheit dazu eingerichtet ist, alle Schutzstufen der jeweiligen Schutzfunktion der Vielzahl von Schutzfunktionen, insbesondere der ausgewählten Schutzfunktion und/oder der anderen Schutzfunktion, zu aktivieren. Mit anderen Worten, die Steuereinheit kann dazu eingerichtet sein, alle Schutzstufen aller Schutzfunktionen gleichzeitig zu aktivieren. Beispielsweise kann nach einem Ende des Testlaufs die Steuereinheit dazu eingerichtet sein, mittels eines manuellen Aktivierens alle Schutzstufen aller Schutzfunktionen gleichzeitig anzuwählen oder zu aktivieren. Hierdurch ergibt sich der Vorteil, dass leichter sichergestellt werden kann, dass nach dem Ende des Testlaufs alle Schutzfunktionen wieder aktiv sind. Dies kann die Wahrscheinlichkeit reduzieren, dass das Aktivieren einer Schutzstufe und/oder einer Schutzfunktion nach dem Ende des Testlaufs vergessen wurde.

Die Erfindung betrifft auch ein Schutzrelais umfassend die besagte Steuereinheit. Die Steuereinheit kann hier insbesondere dazu ausgebildet sein, das Schutzrelais zu öffnen und/oder zu schließen. Das Schutzrelais kann als digitales Schutzrelais ausgebildet sein.

Die Erfindung betrifft auch eine Kommunikationsschnittstelle für eine Steuereinheit eines Schutzrelais, welche in einem Speicher eine Vielzahl von Schutzfunktionen jeweils umfassend zumindest eine Schutzstufe gespeichert hat und welche dazu eingerichtet ist, ein Signal für eine Schutzauslösung des Schutzrelais auszugeben, wenn die jeweilige Schutzstufe von zumindest einem Betriebsparameter des Schutzrelais ausgelöst wurde, und/oder für ein Schutzrelaistestgerät, welches einen Testplan von zumindest einer ausgewählten Schutzstufe einer ausgewählten Schutzfunktion aus der Vielzahl von Schutzfunktionen gespeichert hat. Die Kommunikationsschnittstelle ist dazu eingerichtet, die zumindest eine ausgewählte Schutzstufe der ausgewählten Schutzfunktion zu empfangen und ein Testsignal an die Steuereinheit auszugeben.

Erfindungsgemäß ist das Testsignal dazu ausgebildet, die zumindest eine ausgewählte Schutzstufe der ausgewählten Schutzfunktion aktiv zu lassen oder zu aktivieren und alle anderen Schutzstufen der ausgewählten Schutzfunktion und/oder anderer Schutzfunktionen der Vielzahl von Schutzfunktionen zu deaktivieren.

Mit anderen Worten, die Kommunikationsschnittstelle kann die besagte Datenstruktur, umfassen, und mittels der Datenstruktur ein Ausgangssignal des Schutzrelaistestgeräts und/oder eine Eingabe über eine Benutzerschnittstelle mittels der Datenstruktur in das besagte Testsignal zu konvertieren, wobei das Testsignal dazu ausgebildet sein kann, die Steuereinheit zu veranlassen, zumindest eine zu testende Schutzstufe einer Schutzfunktion aus der Vielzahl von Schutzfunktionen auszuwählen und nur die Schutzstufe der zu testenden Schutzfunktion zu aktivieren oder aktiv zu lassen und alle anderen Schutzstufen derselben Schutzfunktion und/oder aller anderen Schutzfunktionen der Vielzahl von Schutzfunktionen zu deaktivieren.

Ergänzend oder alternativ kann das Testsignal so ausgebildet sein, die Steuereinheit des Schutzrelais zu veranlassen, nur die zu testende Schutzfunktion aktiv zu lassen und alle anderen Schutzfunktionen der Vielzahl von Schutzfunktionen zu deaktivieren.

Die Kommunikationsschnittstelle kann dazu eingerichtet sein, die zumindest eine ausgewählte Schutzstufe oder Schutzfunktion von dem Schutzrelaissteuergerät und/oder mittels der Eingabe über die Benutzerschnittstelle zum Empfangen, insbesondere mittels eines Ausgabesignals des Schutzrelaistestgeräts. Das Schutzrelaistestgerät kann dazu eingerichtet sein, eine Betriebsumgebung des Schutzrelais, insbesondere einen Fehlerfall der Betriebsumgebung, zu simulieren.

Ergänzend oder alternativ kann das Ausgangssignal und/oder das Testsignal einen Pointer zu der zu testenden Schutzfunktion und/oder die zu testende Schutzfunktion und/oder einen Zeitstempel der gemäß dem Testplan zu testenden Schutzfunktion umfassen.

Ergänzend kann die Kommunikationsschnittstelle dazu eingerichtet sein, die Aufgabe der oben beschriebenen Steuereinheit für ein Schutzrelais zu übernehmen.

Beispielsweise kann die Steuereinheit des Schutzrelais die Vielzahl der Schutzfunktionen umfassen und das Schutzrelaistestgerät kann einen entsprechenden Testplan der Vielzahl von Schutzfunktionen umfassen. Beispielsweise kann der Testplan eine Testablaufdatei umfassen, welche das Schutzrelaistestgerät gespeichert hat, wobei die Steuereinheit des Schutzrelais und/oder die Kommunikationsschnittstelle eine korrespondierende Testablaufdatei gespeichert haben kann. Die Kommunikationsschnittstelle kann dabei eingerichtet sein, das Ausgangssignal des Schutzrelaistestgeräts mittels der besagten Datenstruktur in das Testsignal für die Steuereinheit des Schutzrelais basierend auf dem Testplan, insbesondere auf der Testablaufdatei, zu konvertieren. Die Testablaufdatei kann beispielsweise von einem Dateiformat einer *.occ-Datei oder einem Äquivalent dazu sein.

Hierdurch ergibt sich der Vorteil, dass die Vorteile der oben beschriebenen Steuereinheit für ein Schutzrelais für bereits bestehende Schutzrelais ohne diese Steuereinheit erreicht werden können. Hier kann eine Wechselwirkung zwischen den Schutzfunktionen bei einem Testlauf der Vielzahl von Schutzfunktionen vermieden werden. Weiterhin müssen die jeweiligen Schutzstufen nicht mehr von Hand einzeln aktiviert oder deaktiviert werden, sondern können auf der Ebene der Schutzfunktionen aktiviert oder deaktiviert werden. Dies gestaltet den Testlauf einfacher und ermöglicht ferner eine Automatisierung des Testlaufs ohne eine Umrüstung von bestehenden Schutzrelais.

Zur Kommunikationsschnittstelle gehören auch Ausführungsformen, durch die sich weitere Vorteile ergeben.

Eine Ausführungsform sieht vor, dass die Kommunikationsschnittstelle dazu eingerichtet ist, einen Start und/oder ein Ende eines Testlaufs der Vielzahl von Schutzfunktionen zu erkennen. Mit anderen Worten, die Kommunikationsschnittstelle kann dazu eingerichtet sein, ein Ausgangssignal eines Schutzrelaistestgeräts, welches insbesondere einen Testplan von zumindest einer ausgewählten Schutzstufe einer ausgewählten Schutzfunktion aus der Vielzahl von Schutzfunktionen gespeichert hat, zu empfangen. Die Kommunikationsschnittstelle kann dazu eingerichtet sein, basierend auf dem Testplan den Start und/oder das Ende des Testlaufs zu bestimmen. Hierdurch ergibt sich der Vorteil, dass zum Start des Testlaufs alle Schutzstufen aller Schutzfunktionen deaktiviert werden können und zum Ende des Testlaufs alle Schutzstufen aller Schutzfunktionen wieder aktiviert werden können. Dies kann eine Automatisierung des Testlaufs ermöglichen.

Eine Ausführungsform sieht vor, dass das Testsignal dazu ausgebildet ist, die Steuereinheit des Schutzrelais zu veranlassen, alle Schutzstufen der jeweiligen Schutzfunktion der Vielzahl von Schutzfunktionen, insbesondere der ausgewählten Schutzfunktion und/oder der anderen Schutzfunktion, zu deaktivieren. Mit anderen Worten, das Testsignal kann dazu ausgebildet sein, alle Schutzfunktionen, insbesondere die zugehörige Schutzstufe, des Schutzrelais zu deaktivieren. Hierdurch ergibt sich der Vorteil, dass sichergestellt werden kann, dass während des Testlaufs nur die zu testende Schutzstufe oder Schutzfunktion aktiv ist. Ferner kann die Wahrscheinlichkeit einer Wechselwirkung zwischen zumindest zwei Schutzfunktionen weiter reduziert werden.

Eine Ausführungsform sieht vor, dass das Testsignal dazu ausgebildet ist, die Steuereinheit des Schutzrelais zu veranlassen, alle Schutzstufen der jeweiligen Schutzfunktion der Vielzahl von Schutzfunktionen, insbesondere der ausgewählten Schutzfunktion und/oder der anderen Schutzfunktion, zu aktivieren. Mit anderen Worten, das Testsignal kann dazu ausgebildet sein, alle Schutzfunktionen, insbesondere die zugehörige Schutzstufe, des Schutzrelais zu aktivieren. Hierdurch ergibt sich der Vorteil, dass leichter sichergestellt werden kann, dass nach dem Ende des Testlaufs alle Schutzfunktionen wieder aktiv sind. Dies kann die Wahrscheinlichkeit reduzieren, dass das Aktivieren einer Schutzstufe und/oder einer Schutzfunktion nach dem Ende des Testlaufs vergessen wurde.

Die Kommunikationsschnittstelle kann auch die Merkmale der entsprechenden Steuereinheit und jede Kombination der entsprechenden Ausführungsformen umfassen, insbesondere mit den erforderlichen Änderungen.

Die Erfindung betrifft auch ein Schutzrelaistestgerät und/oder eine Steuereinheit für ein Schutzrelais und/oder ein Schutzrelais und/oder ein Testaufbau für ein Schutzrelais umfassend die besagte Kommunikationsschnittstelle.

Die Erfindung betrifft auch ein Verfahren zum Testen eines Schutzrelais umfassend eine Steuereinheit, welche in einem Speicher eine Vielzahl von Schutzfunktionen gespeichert hat, wobei die jeweilige Schutzfunktion jeweils zumindest eine Schutzstufe umfasst und die Steuereinheit ein Signal für eine Schutzauslösung des Schutzrelais ausgibt, wenn die jeweilige Schutzstufe von zumindest einem Betriebsparameter des Schutzrelais ausgelöst wurde, umfassend die Schritte:
- Auswählen von zumindest einer zu testenden Schutzstufe einer zu testenden Schutzfunktion aus der Vielzahl von Schutzfunktionen; und
- Aktiv Lassen oder Aktivieren der zumindest einen ausgewählten Schutzstufe der ausgewählten Schutzfunktion und Deaktivieren aller anderen Schutzstufen der ausgewählten Schutzfunktion und/oder anderer Schutzfunktionen der Vielzahl von Schutzfunktionen.

Mit anderen Worten, die zu testende Schutzfunktion oder eine zu testende Schutzstufe kann aus der Vielzahl der Schutzfunktionen insbesondere mittels der oben beschriebenen Datenstruktur ausgewählt werden, insbesondere von der besagten Steuereinheit und/oder einem Schutzrelaistestgerät und/oder der besagten Kommunikationsschnittstelle. Die zumindest eine ausgewählte, zu testende Schutzstufe kann aktiv gelassen werden oder aktiviert werden und alle anderen Schutzstufen können insbesondere mittels der besagten Datenstruktur deaktiviert oder abgewählt werden.

Hierdurch ergibt sich der Vorteil, dass eine Wechselwirkung zwischen den Schutzfunktionen bei einem Testlauf der Vielzahl von Schutzfunktionen vermieden werden kann. Weiterhin müssen die jeweiligen Schutzstufen nicht mehr von Hand einzeln aktiviert oder deaktiviert werden, sondern können auf der Ebene der Schutzfunktionen aktiviert oder deaktiviert werden. Dies gestaltet den Testlauf einfacher und ermöglicht ferner eine Automatisierung des Testlaufs.

Zum Verfahren gehören auch Ausführungsformen, durch die sich weitere Vorteile ergeben.

Eine Ausführungsform sieht vor, dass das Verfahren weiter den Schritt umfasst:
- Erkennen eines Starts und/oder eines Endes eines Testlaufs der Vielzahl von Schutzfunktionen.

Mit anderen Worten, der Start und/oder das Ende des Testlaufs kann basierend auf ein Empfangen einer Benutzereingabe oder basierend auf ein Empfangen eines Ausgangssignals eines Schutzrelaistestgeräts erkannt werden. Dieser Schritt kann beispielsweise von der Kommunikationsschnittstelle durchgeführt werden. Hierdurch ergibt sich der Vorteil, dass zum Start des Testlaufs alle Schutzstufen aller Schutzfunktionen deaktiviert werden können und zum Ende des Testlaufs alle Schutzstufen aller Schutzfunktionen wieder aktiviert werden können.

Eine Ausführungsform sieht vor, dass das Verfahren weiter den Schritt umfasst:
- Aktivieren oder Deaktivieren aller Schutzstufen der jeweiligen Schutzfunktion der Vielzahl von Schutzfunktionen, insbesondere der ausgewählten Schutzfunktion und/oder der anderen Schutzfunktion.

Mit anderen Worten, alle Schutzfunktionen, insbesondere die zugehörige Schutzstufe, des Schutzrelais können aktiviert oder deaktiviert werden. Beispielsweise können alle Schutzstufen oder Schutzfunktionen zum Start des Testlaufs deaktiviert und zum Ende des Testlaufs wieder aktiviert werden. Hierdurch ergibt sich der Vorteil, dass zum Start des Testlaufs alle Schutzstufen aller Schutzfunktionen deaktiviert werden können und dass zum Ende des Testlaufs alle Schutzstufen aller Schutzfunktionen wieder aktiviert werden können. Hierdurch kann ferner leichter sichergestellt werden kann, dass nach dem Ende des Testlaufs alle Schutzfunktionen wieder aktiv sind. Dies kann die Wahrscheinlichkeit reduzieren, dass das Aktivieren einer Schutzstufe und/oder einer Schutzfunktion nach dem Ende des Testlaufs vergessen wurde.

Das Verfahren kann auch die Merkmale der entsprechenden Steuereinheit und/oder der Kommunikationsschnittstelle und jede Kombination der entsprechenden Ausführungsformen umfassen, insbesondere mit den erforderlichen Änderungen.

Die Erfindung betrifft auch ein Computerprogramm umfassend Anweisungen, die, wenn das Programm von einem Computer, insbesondere von einer Steuereinheit eines Schutzrelais und/oder von einem Schutzrelaistestgerät und/oder von einem Steuergerät einer Kommunikationsschnittstelle zwischen der Steuereinheit und dem Schutzrelaistestgerät, ausgeführt wird, den Computer dazu veranlassen, die Schritte des besagten Verfahrens auszuführen. Der Computer kann ein Personal Computer (PC) sein oder ein Steuergerät. Ergänzend kann der Computer und/oder das Steuergerät Mittel umfassen, um das oben beschriebene Verfahren durchzuführen.

Beispielsweise kann der Computer Mittel umfassen, welche geeignet sind, ein Schutzrelais zu betreiben, insbesondere zu öffnen und/oder zu schließen und/oder ein Signal für eine Schutzauslösung auszugeben, wenn beispielsweise ein Betriebsparameter des Schutzrelais eine entsprechende Schutzstufe überschreitet. Die Mittel können ergänzend oder alternativ dazu geeignet sein, einen Testaufbau oder ein Testterminal für ein Schutzrelais zu betreiben, insbesondere um ein Schutzrelaistestgerät und/oder eine Kommunikationsschnittstelle zwischen dem Schutzrelaistestgerät und der Steuereinheit des Schutzrelais zu betreiben.

Die Erfindung betrifft auch ein computerlesbares Speichermedium, auf dem das besagte Computerprogramm gespeichert ist. Mit anderen Worten, das computerlesbare Speichermedium kann eine Lochkarte, ein (Disketten-)Speichermedium, eine Festplatte, eine CD, eine DVD, ein USB (Universal Serial Bus)-Speichergerät, ein RAM (Random Access Memory), ein ROM (Read Only Memory) und/oder ein EPROM (Erasable Programmable Read Only Memory) sein. Vorzugsweise kann das computerlesbare Speichermedium ein RAM oder ein ROM sein, wobei insbesondere ein Flash-Speicher verwendet wird. Bei dem computerlesbaren Speichermedium kann es sich auch um ein Datenkommunikationsnetz handeln, das das Herunterladen eines Programmcodes ermöglicht, wie z.B. das Internet.

Die Erfindung betrifft auch einen Computer, insbesondere eine Steuereinheit eines Schutzrelais und/oder ein Schutzrelaistestgerät und/oder ein Steuergerät einer Kommunikationsschnittstelle zwischen der Steuereinheit und dem Schutzrelaistestgerät, umfassend das besagte computerlesbare Speichermedium, auf dem insbesondere das besagte Computerprogramm gespeichert ist. Der Computer kann eine speicherprogrammierbare Steuerung (SPS) oder ein Personal Computer (PC) oder ein Steuergerät sein. Der Computer kann mindestens einen Prozessor und das computerlesbare Speichermedium umfassen, wobei das computerlesbare Speichermedium das Computerprogramm enthält, das, wenn es von dem mindestens einen Prozessor ausgeführt wird, den Computer dazu veranlasst, das oben beschriebene Verfahren durchzuführen. Mit anderen Worten, der mindestens eine Prozessor kann ein Mikroprozessor und/oder ein Mikrocontroller und/oder ein FPGA (Field Programmable Gate Array) und/oder ein DSP (Digitaler Signalprozessor) sein.

Ergänzend oder alternativ kann der Computer eine Steuereinheit eines Schutzrelais und/oder ein Schutzrelaistestgerät und/oder ein Steuergerät einer Kommunikationsschnittstelle zwischen der Steuereinheit und dem Schutzrelaistestgerät sein.

Der Computer kann Mittel zur Durchführung des Verfahrens umfassen. Beispielsweise kann der Computer Mittel umfassen, welche geeignet sind, ein Schutzrelais zu betreiben, insbesondere zu öffnen und/oder zu schließen und/oder ein Signal für eine Schutzauslösung auszugeben, wenn beispielsweise ein Betriebsparameter des Schutzrelais eine entsprechende Schutzstufe auslöst. Die Mittel können ergänzend oder alternativ dazu geeignet sein, einen Testaufbau oder ein Testterminal für ein Schutzrelais zu betreiben, insbesondere um ein Schutzrelaistestgerät und/oder eine Kommunikationsschnittstelle zwischen dem Schutzrelaistestgerät und der Steuereinheit des Schutzrelais zu betreiben.

Die Erfindung umfasst auch Realisierungen, die eine Kombination der Merkmale mehrerer der beschriebenen Ausführungsformen umfassen.

### Kurze Beschreibung der Figuren

Bevorzugte weitere Ausführungsformen der Erfindung werden durch die nachfolgende Beschreibung der Figuren näher erläutert. Dabei zeigen:
- Figur 1: eine schematische Darstellung des Schutzrelais, dessen Schutzfunktionen von einem Schutzrelaistestgerät in einem Testaufbau getestet werden; und
- Figur 2: ein schematisches Flussdiagramm eines Verfahrens zum Testen der Schutzfunktionen oder einzelner Schutzstufen des Schutzrelais.

Im Folgenden werden bevorzugte Ausführungsbeispiele anhand der Figuren beschrieben. Dabei werden gleiche, ähnliche oder gleichwirkende Elemente in den unterschiedlichen Figuren mit identischen Bezugszeichen versehen, und auf eine wiederholte Beschreibung dieser Elemente wird teilweise verzichtet, um Redundanzen zu vermeiden.

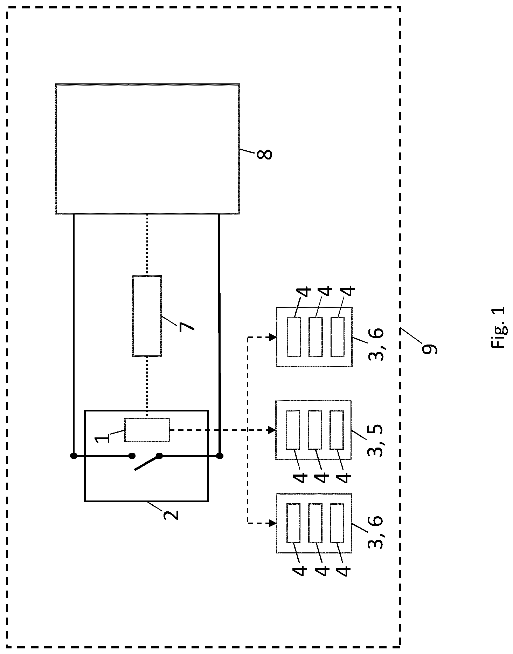

Figur 1 zeigt schematisch einen Testaufbau 9 für ein Schutzrelais 2 umfassend ein Schutzrelais 2 und ein Schutzrelaistestgerät 8, wobei das Schutzrelaistestgerät 8 elektrisch und/oder kommunikativ mit dem Schutzrelais 2, insbesondere mit der Steuereinheit 1 des Schutzrelais 2 verbunden ist. Das Schutzrelais 2 umfasst eine Steuereinheit 1, welche eine Vielzahl von Schutzfunktionen 3 gespeichert hat, wobei die jeweilige Schutzfunktion 3 zumindest eine Schutzstufe 4 umfasst. Der Schutzstufe 4 kann beispielsweise ein zur Schutzfunktion 3 zugehöriger Schwellenwert oder eine Kombination des Schwellenwerts und eines zugehörigen Zeitschwellenwerts sein. Ein Auslösen der Schutzstufe 4 durch zumindest einen Betriebsparameter des Schutzrelais 2, beispielsweise durch ein Überschreiten zumindest eines Betriebsparameters über jeweils einen Schwellenwert und/oder den Zeitschwellenwert, veranlasst die Steuereinheit 1 dazu, das Schutzrelais zu öffnen, insbesondere um Netzwerkkomponenten eines elektrischen Netzes (nicht dargestellt!) vor einer Beschädigung zu schützen. Der Betriebsparameter kann beispielsweise eine Spannung, ein Strom und/oder eine Netzfrequenz umfassen, wobei die Schutzstufe 4 einen dazu entsprechender Schwellenwert umfassen kann.

Während des Betriebs des Schutzrelais 2 im elektrischen Netz ist in der Steuereinheit 1 die Vielzahl der Schutzfunktionen 3, insbesondere zumindest eine zugehörige Schutzstufe 4, aktiv. Hier muss für ein Testen der jeweiligen Schutzstufe 4 einer ausgewählten Schutzfunktion 5 zumindest eine andere Schutzstufe 4 in der ausgewählten Schutzfunktion 5 und/oder in anderen Schutzfunktionen 6 der Vielzahl von Schutzfunktionen 3 einzeln und insbesondere manuell deaktiviert werden. Dies ist zeitaufwendig und kann dazu führen, dass bei einem Vergessen des Deaktivierens einer Schutzstufe 4, insbesondere aus einer anderen Schutzfunktion 6, die gerade nicht getestet werden soll, es zu Wechselwirkungen zwischen der Schutzstufe 4 der anderen Schutzfunktion 6 mit dem Schutzstufe 4 der zu testenden Schutzfunktion 5 während einem Testlauf kommen kann. Für das Testen der jeweiligen Schutzstufe 4 oder Schutzfunktion 3, 5 kann das Schutzrelaistestgerät 8 dazu eingerichtet sein, zumindest einen Betriebsparameter des Schutzrelais 2, insbesondere das elektrische Netz, zu simulieren und über die elektrische Verbindung mit dem Schutzrelais 2 auf das Schutzrelais 2 anzuwenden.

Für ein Vereinfachen des Testlaufs und insbesondere des Testens des Schutzrelais 2 und zur Vermeidung der besagten Wechselwirkungen, wird nur zumindest eine ausgewählte Schutzstufe 4 der ausgewählten Schutzfunktion 5 aktiv gelassen oder aktiviert und alle anderen Schutzstufen 4 in derselben Schutzfunktion 5 und/oder in allen anderen Schutzfunktionen der Vielzahl der Schutzfunktionen 3 deaktiviert. Hierdurch wird nur die ausgewählte Schutzstufe 4 und/oder die ausgewählte Schutzfunktion 5, insbesondere alle Schutzstufen 4 der ausgewählten Schutzfunktion 5, getestet.

Ergänzend oder alternativ wird nur die ausgewählte Schutzfunktion 5 aktiv gelassen oder aktiviert und alle anderen Schutzfunktionen 6 der Vielzahl von Schutzfunktionen werden deaktiviert. Ein Auswählen und/oder ein Aktivieren und/oder ein aktiv Lassen und/oder ein Deaktivieren einer Schutzfunktion 3 kann dabei das Auswählen und/oder ein Aktivieren und/oder ein aktiv Lassen und/oder ein Deaktivieren aller Schutzstufen 4 der Schutzfunktion 5 umfassen.

Die Steuereinheit 1 ist hierzu dazu ausgebildet, dies durchzuführen. Hierzu kann die Steuereinheit 1 eine in einem Speicher gespeicherte Datenstruktur umfassen, welche die jeweiligen Schutzstufe 4 mit ihrer jeweiligen Schutzfunktion 3 verknüpft, so dass durch ein Aktivieren oder Deaktivieren der Schutzfunktion 3 sämtliche zur Schutzfunktion 3 zugehörigen Schutzstufen 4 aktiviert oder deaktiviert werden.

Die besagte Datenstruktur kann so ausgebildet sein, dass die jeweilige Schutzstufe 4 einer Schutzfunktion 5 mit allen anderen Schutzstufen 4 aller anderen Schutzfunktionen 6 der Vielzahl von Schutzfunktionen 3 verknüpft ist, so dass durch ein Aktivieren der Schutzstufe 4 in einer Schutzfunktion 5 aus der Vielzahl von Schutzfunktionen 3 alle anderen Schutzstufen 4 in derselben Schutzfunktion 5 und/oder in allen anderen Schutzfunktionen 6 aus der Vielzahl von Schutzfunktionen 3 deaktiviert werden.

Ergänzend oder alternativ kann die besagte Datenstruktur so ausgebildet sein, dass die jeweilige Schutzstufe 4 mit einer dazugehörigen Schutzfunktion 5 verknüpft ist, so dass durch ein Aktivieren oder Deaktivieren der Schutzfunktion 5, insbesondere der anderen Schutzfunktionen 6 aus der Vielzahl von Schutzfunktionen 6, alle dazugehörigen Schutzstufen 4 aktiviert oder deaktiviert werden.

Der Schutzstufe 4 kann beispielsweise gemäß dem Standard IEEE/ANSI 37.2 zur einer Schutzfunktion 3 zugeordnet sein.

Ergänzend ist die Steuereinheit 1 dazu eingerichtet, alle Schutzfunktionen 3 der Vielzahl von Schutzfunktionen 3 gleichzeitig zu deaktivieren, beispielsweise ausgelöst durch ein Signal oder durch eine Benutzereingabe.

Ergänzend ist die Steuereinheit 1 dazu eingerichtet, alle Schutzfunktionen 3 der Vielzahl von Schutzfunktionen 3 gleichzeitig zu aktivieren, beispielsweise ausgelöst durch ein Signal oder durch eine Benutzereingabe.

Ergänzend oder alternativ kann mittels einer Kommunikationsschnittstelle 7 für ein Schutzrelais 2 und/oder für das Schutzrelaistestgerät 8 ein Schutzrelais 2 getestet werden, welches eine andere als die besagte Steuereinheit 1 aufweist.

Hierzu kann das Schutzrelaistestgerät 8 über die Kommunikationsschnittstelle 7 mit der Steuereinheit 1 des Schutzrelais kommunikativ verbunden sein. Die Kommunikationsschnittstelle 7 ist dazu ausgebildet, zumindest eine Schutzstufe 4 einer Schutzfunktion 5 in der Steuereinheit 1 des Schutzrelais 2 aktiv zu lassen oder zu aktivieren und alle anderen Schutzstufen 4 in derselben Schutzfunktion 5 und/oder in anderen Schutzfunktionen 6 der Vielzahl von Schutzfunktionen 3 zu deaktivieren. Hierzu umfasst die Kommunikationsschnittstelle 7, insbesondere ein Steuergerät der Kommunikationsschnittstelle 7, einen Speicher, welcher die besagte Datenstruktur gespeichert hat.

Das Schutzrelaistestgerät 8 kann hierzu dazu eingerichtet sein, eine Auswahl von zumindest einer zu testenden Schutzstufe 4 einer zu testenden Schutzfunktion 5 aus der Vielzahl von Schutzfunktionen 3 zu bestimmen. Hierzu können die Steuereinheit 1 und das Schutzrelaistestgerät 8 die Vielzahl der Schutzfunktionen 3, insbesondere einen Testablauf der Vielzahl von Schutzfunktionen 3 und/oder Schutzstufen 4, jeweils in einem Speicher gespeichert haben, wobei das Schutzrelaistestgerät 8 dazu eingerichtet ist, ein Ausgangssignal an die Kommunikationsschnittstelle 7 auszugeben, welches von der Kommunikationsschnittstelle 7 in ein Testsignal konvertiert und an die Steuereinheit 2 des Schutzrelais 2 ausgegeben wird.

Das Testsignal ist dabei so ausgebildet, die Steuereinheit 1 zu veranlassen, die zumindest eine zu testende Schutzstufe 4 der zu testenden Schutzfunktion 5 aktiv zu lassen oder zu aktiveren und alle anderen Schutzstufen 4 in derselben Schutzfunktion 5 und/oder in anderen Schutzfunktionen 6 aus der Vielzahl von Schutzfunktionen zu deaktivieren. Dies kann beispielsweise durch eine Ausgabe des Testsignals durch die Kommunikationsschnittstelle 7 synchron zum Testablauf der Vielzahl von Schutzfunktionen 3 erfolgen, wobei der Testlauf insbesondere in dem Schutzrelaistestgerät 8 und/oder der Kommunikationsschnittstelle 7 und/oder in der Steuereinheit 1 gespeichert ist.

Ergänzend oder alternativ kann das Testsignal eine Auswahl der zu testenden Schutzfunktion 5 umfassen, insbesondere einen Pointer auf die zu testende Schutzfunktion 5.

Ergänzend ist die Kommunikationsschnittstelle 7 dazu eingerichtet, einen Start eines Testlaufs der Vielzahl von Schutzfunktionen 3 zu erkennen und ein Testsignal an die Steuereinheit 1 des Schutzrelais 2 auszugeben, welches die Steuereinheit 1 dazu veranlasst, alle Schutzstufen 4 aller Schutzfunktionen 3 oder alle Schutzfunktionen 3 zu deaktivieren.

Ergänzend oder alternativ ist die Kommunikationsschnittstelle 7 dazu eingerichtet, ein Ende des Testlaufs der Vielzahl von Schutzfunktionen 3 zu erkennen und ein Testsignal an die Steuereinheit 1 des Schutzrelais 2 auszugeben, welches die Steuereinheit 1 dazu veranlasst, alle Schutzstufen 4 aller Schutzfunktionen 3 oder alle Schutzfunktionen 3 zu aktivieren.

Das Schutztestgerät kann beispielsweise mittels einer Testablaufdatei einen vordefinierten Testplan abfahren und somit eine Vielzahl von Schutzfunktionen und Schutzebenen automatisiert und kontinuierlich prüfen.

Die verschiedenen Schutzfunktionen 3 (Schutzstufen 4) beeinflussen sich oft gegenseitig. Für einen vollautomatischen Prüfablauf muss daher immer nur diejenige Schutzfunktion 3 (Schutzstufe 4) im Schutzrelais 2 aktiv sein, die gerade vom Schutztestgerät 8 aus der Vielzahl von Schutzfunktionen 3 (Schutzstufen 4) ausgewählt wird.

Beispielsweise kann das Schutzrelais 2, insbesondere die Steuereinheit 1, einen digitalen Eingang umfassen. Dieser wird mit einem digitalen Ausgang des Schutzrelaistestgeräts 8 verbunden. Durch ein Aktivieren des digitalen Ausgangs des Schutzrelaistestgeräts 8, beispielsweise von logisch 0 auf logisch 1 des Ausgangssignals und/oder des Testsignals, wird immer die nächste Schutzfunktion 3 (Schutzstufe 4) in der vorgegebenen Reihenfolge (wie in der Testablaufdatei für das Schutzrelaistestgerät 8) aktiviert und die entsprechende Prüfung durchgeführt. Danach wird dieser Digitalausgang vom Schutzrelaistestgerät 8 wieder kurz aktiviert und damit die nächste Schutzfunktion 3 (Schutzstufe 4) des Schutzrelais 2 aktiviert usw., bis alle Schutzfunktionen 3 (alle Schutzstufen 4, insbesondere aller Schutzfunktionen 3) getestet sind.

Ergänzend kann für jede geprüfte oder getestete Schutzfunktion 3 (Schutzstufe 4) im Schutzrelaistestgerät 8 ein Schutzbericht (Störschrieb) aufgezeichnet und gespeichert werden. Hierdurch ergibt sich der Vorteil, dass die durchgeführten Prüfungen automatisch protokolliert werden.

Damit kann die zu testende Schutzfunktion 5 (Schutzstufe 4) einfach und schnell ohne Fehlauslösung oder Wechselwirkung durch eine andere Schutzfunktion 6 geprüft oder getestet und protokolliert werden. Weiterhin kann das Testen der Schutzfunktionen 3 (Schutzstufen 4) des Schutzrelais 2 automatisch durchgeführt werden. Weiterhin kann sichergestellt werden, dass nach dem Testlauf alle Schutzfunktionen 3 (Schutzstufen 4) wieder aktiv sind.

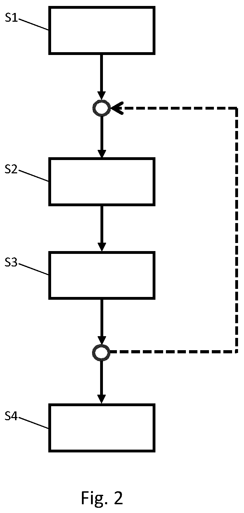

Figur 2 zeigt ein schematisches Flussdiagramm eines Verfahrens zum Testen eines Schutzrelais 2 umfassend die Steuereinheit 1, welche in einem Speicher die Vielzahl von Schutzfunktionen 3 gespeichert hat. Dieses Verfahren kann von der Steuereinheit 1 umfassend die Vielzahl der Schutzfunktionen 3 und/oder dem Schutzrelaistestgerät 8 umfassend einen Testplan der Vielzahl von Schutzfunktionen 3 und/oder einer Kommunikationsschnittstelle zwischen dem Schutzrelaistestgerät 8 und der Steuereinheit 1 durchgeführt werden.

In einem optionalen ersten Schritt S1 wird ein Start eines Testlaufs der Vielzahl von Schutzfunktionen 3 bestimmt oder erkannt und alle Schutzstufen 4 und/oder alle Schutzfunktionen 3 der Vielzahl von Schutzfunktionen 3 deaktiviert.

In einem zweiten Schritt S2 wird zumindest eine zu testende Schutzstufe 4 einer zu testenden Schutzfunktion 5 aus der Vielzahl von Schutzfunktionen 3 ausgewählt.

In einem dritten Schritt S3 wird die zumindest eine ausgewählte Schutzstufe 4 der ausgewählten Schutzfunktion 5 aktiv gelassen oder aktiviert und alle anderen Schutzstufen 4 der ausgewählten Schutzfunktion 5 und/oder anderer Schutzfunktionen 6 der Vielzahl von Schutzfunktionen deaktiviert.

Die Schritte S2 und S3 können für jede Schutzstufe 4 und/oder jede Schutzfunktion 3 der Vielzahl von Schutzfunktionen 3 wiederholt werden, bis alle Schutzstufen 4 und/oder Schutzfunktionen 3 der Vielzahl von Schutzfunktionen 3 und/oder des Testplans getestet wurden. Die Schritte S2 und S3 können N mal wiederholt werden, wobei N eine Anzahl der Wiederholungen sein kann, welche einer Anzahl der Schutzstufen 4 von zumindest einer Schutzfunktion 3 oder der Anzahl der Schutzstufen 4 aller Schutzfunktionen 3 entsprechen kann.

In einem optionalen vierten Schritt S4 wird ein Ende des Testlaufs der Vielzahl von Schutzfunktionen 3 bestimmt oder erkannt und alle Schutzstufen 4 und/oder alle Schutzfunktionen 3 der Vielzahl von Schutzfunktionen 3 aktiviert.

Soweit anwendbar, können alle einzelnen Merkmale, die in den Ausführungsbeispielen dargestellt sind, miteinander kombiniert und/oder ausgetauscht werden, ohne den Bereich der Erfindung zu verlassen.

### Bezugszeichenliste

- 1: Steuereinheit
- 2: Schutzrelais
- 3: Schutzfunktion
- 4: Schutzstufe
- 5: Zu testende Schutzfunktion
- 6: Andere Schutzfunktion
- 7: Kommunikationsschnittstelle
- 8: Schutzrelaistestgerät
- 9: Testaufbau
- N: Anzahl von Wiederholungen
- S1: Erster Schritt
- S2: Zweiter Schritt
- S3: Dritter Schritt
- S4: Vierter Schritt

## Patentansprüche

1. Steuereinheit (1) für ein Schutzrelais (2), welche in einem Speicher eine Vielzahl von Schutzfunktionen (3, 5, 6) jeweils umfassend zumindest eine Schutzstufe (4) gespeichert hat und welche dazu eingerichtet ist, ein Signal für eine Schutzauslösung des Schutzrelais (2) auszugeben, wenn die jeweilige Schutzstufe (4) von zumindest einem Betriebsparameter des Schutzrelais (2) ausgelöst wurde, und zumindest eine ausgewählte Schutzstufe (4) einer ausgewählten Schutzfunktion (5) aktiv zu lassen oder zu aktivieren und alle anderen Schutzstufen (4) der ausgewählten Schutzfunktion (5) und/oder anderer Schutzfunktionen (6) der Vielzahl von Schutzfunktionen (3, 5, 6) zu deaktivieren.

2. Steuereinheit (1) nach Anspruch 1, **dadurch gekennzeichnet, dass** sie dazu eingerichtet ist, alle Schutzstufen (4) der jeweiligen Schutzfunktion (3, 5, 6) der Vielzahl von Schutzfunktionen (3, 5, 6), insbesondere der ausgewählten Schutzfunktion (5) und/oder der anderen Schutzfunktion (6), zu deaktivieren.

3. Steuereinheit (1) nach einem der vorhergehenden Ansprüche, **dadurch gekennzeichnet, dass** sie dazu eingerichtet ist, alle Schutzstufen (4) der jeweiligen Schutzfunktion (3, 5, 6) der Vielzahl von Schutzfunktionen (3, 5, 6), insbesondere der ausgewählten Schutzfunktion (5) und/oder der anderen Schutzfunktion (6), zu aktivieren.

4. Schutzrelais (2) umfassend die Steuereinheit (1) nach einem der Ansprüche 1 bis 3.

5. Kommunikationsschnittstelle (7) für eine Steuereinheit (1) eines Schutzrelais (2), welche in einem Speicher eine Vielzahl von Schutzfunktionen (3, 5, 6) jeweils umfassend zumindest eine Schutzstufe (4) gespeichert hat und welche dazu eingerichtet ist, ein Signal für eine Schutzauslösung des Schutzrelais (2) auszugeben, wenn die jeweilige Schutzstufe (4) von zumindest einem Betriebsparameter des Schutzrelais (2) ausgelöst wurde, und/oder für ein Schutzrelaistestgerät (8), welches einen Testplan von zumindest einer ausgewählten Schutzstufe (4) einer ausgewählten Schutzfunktion (5) aus der Vielzahl von Schutzfunktionen (3, 5, 6) gespeichert hat, welche dazu eingerichtet ist, die zumindest eine ausgewählte Schutzstufe (4) der ausgewählten Schutzfunktion (5) zu empfangen und ein Testsignal an die Steuereinheit (1) auszugeben,
**dadurch gekennzeichnet, dass**
das Testsignal dazu ausgebildet ist, die zumindest eine ausgewählte Schutzstufe (4) der ausgewählten Schutzfunktion (5) aktiv zu lassen oder zu aktivieren und alle anderen Schutzstufen (4) der ausgewählten Schutzfunktion (5) und/oder anderer Schutzfunktionen (6) der Vielzahl von Schutzfunktionen (3, 5, 6) zu deaktivieren.

6. Kommunikationsschnittstelle (7) nach Anspruch 5, **dadurch gekennzeichnet, dass** sie dazu eingerichtet ist, einen Start und/oder ein Ende eines Testlaufs der Vielzahl von Schutzfunktionen (3, 5, 6) zu erkennen.

7. Kommunikationsschnittstelle (7) nach Anspruch 5 oder 6, **dadurch gekennzeichnet, dass** das Testsignal dazu ausgebildet ist, die Steuereinheit (1) des Schutzrelais (2) zu veranlassen, alle Schutzstufen (4) der jeweiligen Schutzfunktion (3, 5, 6) der Vielzahl von Schutzfunktionen (3, 5, 6), insbesondere der ausgewählten Schutzfunktion (5) und/oder der anderen Schutzfunktion (6), zu deaktivieren.

8. Kommunikationsschnittstelle (7) nach einem der Ansprüche 5 bis 7, **dadurch gekennzeichnet, dass** das Testsignal dazu ausgebildet ist, die Steuereinheit (1) des Schutzrelais (2) zu veranlassen, alle Schutzstufen (4) der jeweiligen Schutzfunktion (3, 5, 6) der Vielzahl von Schutzfunktionen (3, 5, 6), insbesondere der ausgewählten Schutzfunktion (5) und/oder der anderen Schutzfunktion (6), zu aktivieren.

9. Schutzrelaistestgerät (8) und/oder eine Steuereinheit (1) für ein Schutzrelais (2) und/oder ein Schutzrelais (2) und/oder ein Testaufbau (9) für ein Schutzrelais (2) umfassend die Kommunikationsschnittstelle (7) nach einem der Ansprüche 5 bis 8.

10. Verfahren zum Testen eines Schutzrelais (2) umfassend eine Steuereinheit (1), welche in einem Speicher eine Vielzahl von Schutzfunktionen (3, 5, 6) gespeichert hat, wobei die jeweilige Schutzfunktion (3, 5, 6) jeweils zumindest eine Schutzstufe (4) umfasst und die Steuereinheit (1) ein Signal für eine Schutzauslösung des Schutzrelais (2) ausgibt, wenn die jeweilige Schutzstufe (4) von zumindest einem Betriebsparameter des Schutzrelais (2) ausgelöst wurde, umfassend die Schritte:
- Auswählen von zumindest einer zu testenden Schutzstufe (4) einer zu testenden Schutzfunktion (5) aus der Vielzahl von Schutzfunktionen (3, 5, 6); und
- Aktiv Lassen oder Aktivieren der zumindest einen ausgewählten Schutzstufe (4) der ausgewählten Schutzfunktion (5) und Deaktivieren aller anderen Schutzstufen (4) der ausgewählten Schutzfunktion (5) und/oder anderer Schutzfunktionen (6) der Vielzahl von Schutzfunktionen (3, 5, 6).

11. Verfahren nach Anspruch 10, weiter umfassend den Schritt:
- Erkennen eines Starts und/oder eines Endes eines Testlaufs der Vielzahl von Schutzfunktionen (3, 5, 6).

12. Verfahren nach Anspruch 10 oder 11, weiter umfassend den Schritt:
- Aktivieren oder Deaktivieren aller Schutzstufen (4) der jeweiligen Schutzfunktion (3, 5, 6) der Vielzahl von Schutzfunktionen (3, 5, 6), insbesondere der ausgewählten Schutzfunktion (5) und/oder der anderen Schutzfunktion (6).

13. Computerprogramm umfassend Anweisungen, die, wenn das Programm von einem Computer, insbesondere von einer Steuereinheit (1) eines Schutzrelais (2) und/oder von einem Schutzrelaistestgerät (8) und/oder von einem Steuergerät einer Kommunikationsschnittstelle (7) zwischen der Steuereinheit (1) und dem Schutzrelaistestgerät (8), ausgeführt wird, den Computer dazu veranlassen, die Schritte des Verfahrens nach einem der Ansprüche 10-12 auszuführen.

14. Computerlesbares Speichermedium, welches das Computerprogramm nach Anspruch 13 gespeichert hat.

15. Computer, insbesondere eine Steuereinheit (1) eines Schutzrelais (2) und/oder ein Schutzrelaistestgerät (8) und/oder ein Steuergerät einer Kommunikationsschnittstelle (7) zwischen der Steuereinheit (1) und dem Schutzrelaistestgerät (8), umfassend das computerlesbare Speichermedium nach Anspruch 14.
